# EUROPEAN PATENT SPECIFICATION

(11) **EP 1 964 943 B1**
(45) Date of publication and mention of the grant of the patent: **14.10.2009**
(21) Application number: 07004187.6
(22) Date of filing: 28.02.2007
(51) Int. Cl.: C23C 14/56, B65H 20/02

(54) **Entry lock system, web processing installation, and method for using the same**
Zugangsversperrsystem, Netzverarbeitungsanlage und Anwendungsverfahren dafür
Système de sas d'entrée, installation de traitement de voile et leur procédé d'utilisation.

(43) Date of publication of application: 03.09.2008
(73) Proprietor: Applied Materials, Inc., Santa Clara, CA 95054 (US)
(72) Inventor: Hein, Stefan, 63825 Blankenbach (DE); Sauer, Peter, 36381 Schlüchtern (DE)
(74) Representative: Zimmermann, Gerd Heinrich

(56) References cited:
- GB-A- 1 187 802
- US-A- 3 316 177
- US-A- 4 501 428
- US-A- 4 962 725
- US-B1- 6 338 872

## Description

### Technical Field of the Invention

The present invention relates to an entry lock system for use in a web processing installation, a web processing installation, and a method for feeding a web processing installation. The present invention relates particularly to an entry lock system that allows the feeding of a web processing installation with web that is supplied from ambient air that is significantly higher than the pressure within the web processing installation.

### Background of the Invention

In many web processing applications such as web coating the pressure within the web processing installation is considerably below the atmospheric pressure. However, the web that is to be processed within those applications is typically fed to the web processing installation from an ambient having atmospheric pressure. It is therefore desirable that the web is fed to the web processing installation in such a way that the vacuum within the web processing installation is not jeopardized.

To this end, it is known in the state of the art to provide seals at the entry of the web processing installation that allow both for the movement of the web into the web processing installation and for the sealing of the web processing installation against the higher pressure in the outside. Although these seals work in theory, they do not seal the inner space of the web processing installation from the atmosphere pressure outside totally at the desired level in practice. For instance, a seal is not able to snuggle along the edges of a moving web. Therefore, tinny free spaces along the edges of the web allow the air from the outside to enter the web processing installation thereby reducing the high vacuum.

Further developments in this regard are so called air-to-air systems. Air-to-air systems are modular lock systems in which the pressure difference is reduced via several pressure stages, i.e. chambers, arranged in series. The individual chambers are connected to each other by apertures. In these systems the web travels through a multitude of chambers with decreasing pressure. In comparison to a single seal arranged at the entry of the web processing installation, the arrangement of the multitude of chambers with decreasing pressure - each sealed against the neighbour chamber - reduces the amount of air that is entering the web processing installation. This is due to the fact that the pressure difference between neighbouring chambers is small in comparison to the total pressure difference between ambient air and web processing installation. However, the provision of a multitude of chambers arranged in series at the entry of a web processing installation comes along with the consumption of much room. Further, air-to-air systems need a huge pumping capacity to provide the pressure stages. Furthermore, the substrate thickness is bounded by a lower limit as strong air flow and turbulences, which are produced within the first pressure stage, can tear the substrate apart.

U.S. Pat. No. 4,501,428 discloses an apparatus for subjecting a workpiece of plastic molding to continuous surface treatment by an air-to-air system in vacuum, including a vacuum treating chamber and a plurality of auxiliary vacuum chambers anterior and posterior to the vacuum treating chamber. The vacuum treating chamber is evacuated via an exhaust pipe by a vacuum pump to achieve under pressure. The vacuum chamber closest to the atmosphere comprises an upper and a lower seal roll, wherein the upper seal roll having a coat of resilient material and the lower seal roll having a coat of hard material applied to its outer periphery. The diameters of the seal rolls constituting the auxiliary vacuum chambers located on the vacuum treating chamber side are made smaller than that of the seal rolls constituting the auxiliary vacuum chamber closest to the atmosphere, therefore energy conservation is to be achieved through a reduction in the drive force for driving the auxiliary vacuum chambers and the amount of air removed therefrom to make a vacuum.

### Summary of the invention

At least some of the problems in the art are overcome by the entry lock system according to claim 1, the web processing installation according to claim 13 and the method for feeding a web processing installation according to claim 15. Further aspects, details and advantages are evident from the dependent claims, the description and the accompanying drawings.

In view of the above, an entry lock system for feeding web from a web supply to a web processing installation is provided. The entry lock system includes a first chamber with an inlet port and an outlet port; a second chamber with an inlet port; a first seal positioned at the inlet port of the first chamber; a second seal positioned between the first chamber and the second chamber; a first web storage unit positioned in the first chamber; and a second web storage unit positioned in the second chamber.

According to another aspect of the present invention, a web processing installation with at least one entry lock system as described herein is provided.

According to another aspect of the present invention, a method for feeding a web processing installation with web is provided. The method includes the steps of:
a) feeding the web from ambient air to a first chamber having a first pressure;
b) storing the web fed to the first chamber in the first chamber;
c) sealing the first chamber and evacuating the first chamber to a second pressure;
d) feeding the web stored in the first chamber to a second chamber having a third pressure;
e) storing the web fed to the second chamber in the second chamber; and
f) sealing the second chamber from the first chamber.

### Brief Description of the Drawings

Embodiments of the present invention will be described with respect to the accompanying drawings in more detail in the following. Therein:
- Fig. 1A, 1B and 1C: show an embodiment of an entry lock system according to the present invention at different process stages.
- Fig. 2, 3 and 4: show various embodiments of the web processing installation according to the present invention.
- Fig. 5: shows an embodiment of an entry lock system according to the present invention with the second chamber being integral part of the web processing installation.
- Fig. 6a and 6b: show an embodiment of a first or second chamber of an entry lock system according to the present invention at different process stages.
- Fig. 7: shows a flow chart of method steps according to a method for feeding a web processing installation according to the present invention.

### Detailed Description of the Embodiments

Reference will now be made in detail to the various embodiments of the invention, one or more examples of which are illustrated in the figures. Each example is provided by way of explanation of the invention, and is not meant as a limitation of the invention. For example, features illustrated or described as part of one embodiment can be used on or in conjunction with other embodiments to yield yet a further embodiment. It is intended that the present invention includes such modifications and variations.

The present invention can be used in all applications where flexible substrates have to be carried continuously from a coil to or through chambers with different pressures. In particular, the present invention can be used for feeding web from ambient atmosphere to vacuum. Within the present application, the terms "web", "foil", "strip", "substrate" and the like are used synonymously.

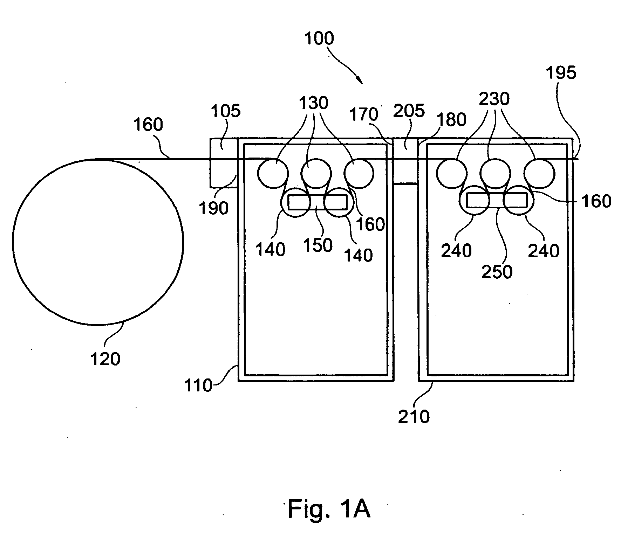

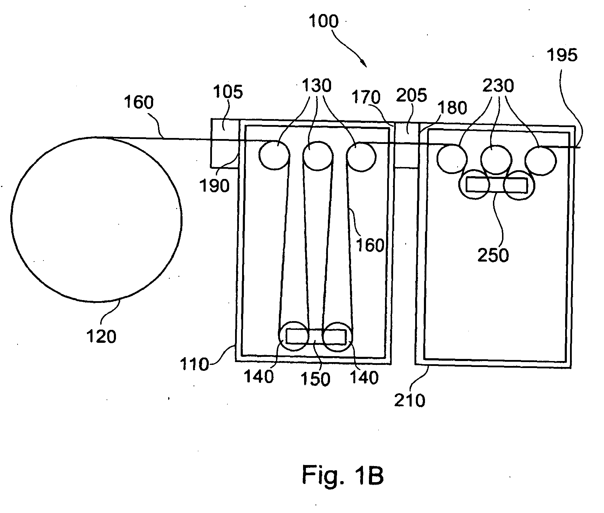

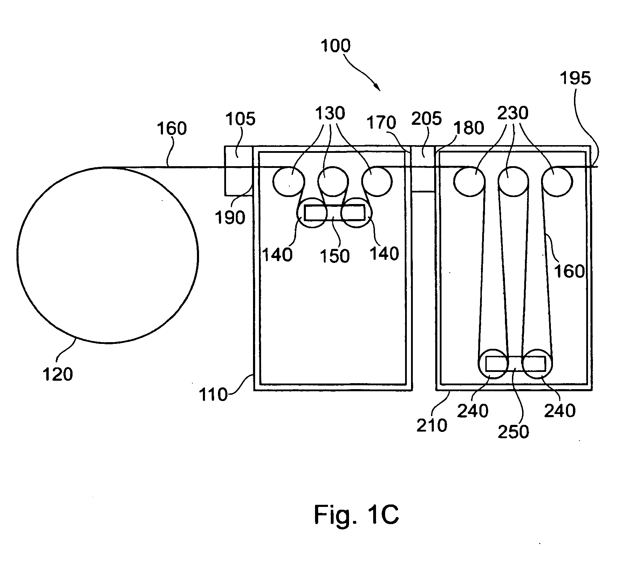

Figure 1 shows an embodiment of the entry lock system according to the present invention. The entry lock system comprises a first chamber 110 and a second chamber 210. A seal 205 is positioned between the outlet port 170 of the first chamber and the inlet port 180 of the second chamber. Another seal 105 is positioned at the inlet port 190 of the first chamber. Both the first chamber and the second chamber provide room for storing a specific amount of web. Typically, according to the present invention, web lengths between 0.5 m and 40 m, in some embodiments between 5 and 20 or between 8 and 12 m can be stored. In some applications between 1 m and 2 m web length are stored in each of the chambers. The web is fed to the entry lock system from the coil 120 via the first seal 105 to the first web storage unit. The first web storage unit is within the first chamber. In the embodiment shown in Fig. 1A, the web storage unit comprises five rollers and a carriage. The rollers 130 have a fixed axis whereas the rollers 140 are movable within the first chamber 110. In the embodiment shown, their moving direction can be up and down within the first chamber. The rollers 140 are connected to each other via the carriage 150.

Typically, the first chamber and the second chamber are in direct contact to each another, i.e., they are immediate neighbours. They may also have a wall in common. Typically, the second seal is positioned at the outlet port of the first chamber and/or at the inlet port of the second chamber.

In typical embodiments of the present invention, the web storage unit comprises rollers with a fixed axis and rollers that are moveable. Typically, the fixed axis rollers are arranged in the upper part of the first and/or second chamber. The moveable rollers can typically perform a one-dimensional translational movement within the first and/or second chamber. That is, the axes of the movable rollers may typically perform a translational movement. In general, the web storage unit comprises at least one moveable roller and at least two fixed axis rollers. Typically, the number of fixed axis rollers is equal to the number of moveable rollers plus 1. In the event that the web storage unit comprises two, three or more moveable rollers, they are typically connected to each other by a carriage or the like. Typically, the number of fixed axis rollers and/or moveable rollers is identical in both the first and the second chamber. Typically, the weight of the movable rollers and/or the carriage connecting the movable rollers is such that the rollers move downwards when web is fed from the coil. It is possible that the chamber comprises guiding rails for guiding the rollers and/or the carriage on their way up and down. In other embodiments, the movable rollers may move externally driven by a drive system such as electromotor or the like.

According to the present invention, the web is fed to the first chamber from a web supply. The web supply is typically a coil with the web coiled. Typical lengths of the web on the coil are in the range between 500 m and 15 km. In other embodiments, the web supply is a processing chamber with an outlet port where the web exits the processing chamber for being fed to the first chamber of the entry lock system according to the present invention.

After travelling along the rollers 130 and 140 in the first chamber, the web 160 exits the first chamber at its outlet port 170 via the seal 205 into the second chamber 210 at its inlet port 180. In the chamber 210, the web has to pass a second web storage unit that - in the embodiment of figs. 1A, 1B and 1C - is identical to the web storage unit of the first chamber. After that, the web exits the second chamber at the outlet port 195. Typically, the outlet port 195 of the second chamber is the entry to a chamber of the web processing unit in that, for instance, the web is cleaned or coated. In typical embodiments of the present invention, the pressure in this chamber, i.e. within the web processing installation, is between 10⁻³ mbar and 10⁻⁵ mbar such as about 10⁻⁴ mbar. The term "about" within the present application is to be understood as including a deviation of +/- 20% from the value specified. A further seal (not shown) may be provided between the outlet port 195 of the second chamber and the inlet of the following chamber (not shown) of the web processing installation.

In general, the first and/or second seal may be flexible vacuum seals. Due to their flexibility, they snuggle well to the web in order to prevent air from passing in between. They can be opened and shut easily. Alternatively, shutter seals and/or slit valves could be used.

In other embodiments, the first and/or second seal are inflatable seals. Those seals can be inflated thereby increasing their volume and pressing the inflatable seals against the web. It is also possible that the seals are rotating seals. These seals provide for a rotating seal surface that moves along with the web from the low pressure side of the seal to the high pressure side of the seal or vice versa. Hence, there is no friction between seal and the web. This is particularly useful with thin webs such as webs having a thickness of between 1 micrometer and 10 micrometer, such as 8 micrometer. Further, in another embodiment of the present invention, a seal as the lock valve disclosed in the international application WO 2005/116501 A1 may be employed as seal at the inlet port of the first chamber, between the first and second chamber, or at the outlet port of the second chamber.

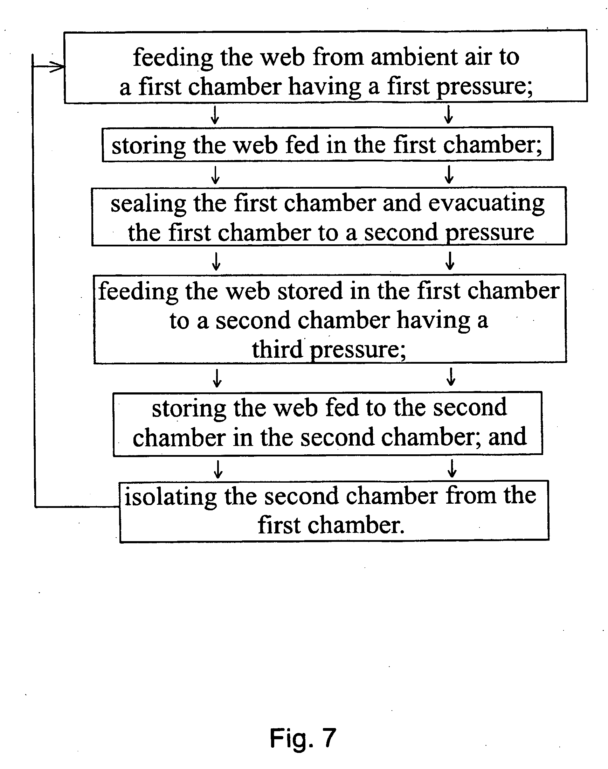

In the following, the way an embodiment of the entry lock system of the present invention works shall be explained with respect to Figs. 1A, 1B, 1C and 7. If a web coil is consumed by the web processing installation, a new coil 120 has to be applied to the web processing installation. The web is mounted to the first and second chamber resulting in a configuration such as shown in Fig. 1A. This step is typically done manually. Alternatively a flying splice can be used. The second seal 205 is shut and both the second chamber and the one or more chambers of the web processing unit that is/are connected to the second chamber are evacuated. At this point in time, web processing can start.

The first web storage unit 130, 140, 150 is operated in such a way that web is stored in the first chamber. This is shown in Fig. 1B where web 160 has been uncoiled from the coil 120 and has been fed through the open seal 105 to the rollers 130, 140. As the second seal 205 had been closed during this feeding, the web in the second chamber did not move during web storing in the first chamber. During uncoiling the web has only been fed to the first chamber. Due to their weight, the movable rollers moved down towards the first chamber bottom thereby storing web between the movable rollers and the rollers with the fixed axis.

Once the first web storage unit in the first chamber is filled, the first seal 105 is shut. In the embodiment shown in Figs. 1A to 1C the web storage unit is filled by the movement of the moveable rollers towards the bottom of the first chamber. Then the first chamber is evacuated. This can be done for instance by one or more vacuum pumps that are arranged at the first chamber or that are connected to the first chamber in such a way to allow air to be removed from the first chamber. Typically, at this stage of the process, the first chamber is evacuated until a pressure is reached that corresponds to the pressure within the second chamber. The pressure within the second chamber is typically identical or similar to the pressure of the chamber following the second chamber. The term "similar" in this context is to be understood as including a deviation of one order of magnitude at most. If gap valves are used, the pressure difference can be up to two orders of magnitude. As stated before, this chamber is typically part of a web processing chamber such as a cleaning or coating chamber.

In general, a chamber is usually sealed prior to an evacuation step. Thereby it is in principal possible to start with the evacuation before the chamber is completely sealed. This depends on the sizes of the chamber to be evacuated and the level of vacuum which shall be achieved. As long as the sealing step is completed to an extend that the evacuation can already be started usefully.

Once a sufficient degree of vacuum is reached within the first chamber, the second seal 205 between the first chamber and the second chamber is opened. The web 160 is fed from the first chamber to the web storage unit of the second chamber. Thereby, the second web storage unit is filled until it is, for instance, completely filled such as shown in Fig. 1C. It should be noted that at this time the pressure within the processing chamber including the first and second chamber is typically similar or identical. That is, depending on the application there is typically no need for sealing the first chamber against the second chamber and/or the second chamber against the following chamber at this time of the process. In other embodiments, the seal between the first and the second chamber remains essentially shut as regards to the air flowing from the first to the second chamber, but allows nevertheless for the movement of the web between the chambers. For instance, a seal may be used that comprises a rotating surface that moves along with the web.

In general, it is possible that a seal is provided at the outlet port 195 of the second chamber. This seal may be shut at the time of storing web in the second web storage unit of the second chamber. The provision of this seal may be useful in these applications where the vacuum level in the second chamber is continuously or temporarily smaller than the vacuum level in the following chamber. However, it is also possible that there is no seal arranged between the second chamber and the following chamber of the web processing installation. A seal such as described above with regard to the seal between the first chamber and the second chamber may be used as seal at the outlet port of the second chamber.

During storing web in the second web storage unit of the second chamber it is generally possible that the feeding of web to the web processing unit arranged downstream of the second chamber is either stopped or continued. For some applications it is not possible to stop the web processing within the web processing installation, the feeding of the web from the second chamber is continued typically until the complete coil is consumed. Then the storage capacity will be adapted to the travelling speed of the web.

Depending of the travelling speed of the web, it is possible in certain applications to even change the coil without stopping the process. In other words, it is possible to have a continuous process with an endless web supply.

Once all the web stored in the first web storage unit of the first chamber is fed to the second web storage unit of the second chamber, the second seal 205 is shut. Web is fed from the second storage unit to the web processing installation via the outlet port 195. Typically at the same time, the first web storage unit is refilled with web that is uncoiled from the web coil 120. In order to do so, the seal 105 is opened which typically results in an airing of the first chamber. Depending on the seal used, airing can be minimized. The less the pressure within the first chamber increases, the less the first chamber has to be evacuated after filling the first web storage unit of the first chamber.

By refilling the first web storage unit the feeding process as described in the previous paragraphs is repeated. According to the present invention, it is possible to continuously feed web to the web processing installation. In other words, the web is fed without any break to the web process installation. In the event of a continuous feeding to the web processing installation, it is necessary that both the filling of the first web storage unit and the subsequent evacuation of the first chamber is completed before the second web storage unit of the second chamber is completely consumed. Typical time intervals for filling the first web storage unit and evacuating the first chamber are between 0.5 min and 5 min such as about 2 min. This time interval depends particularly on the level of vacuum needed. The term "vacuum" within the present application refers to pressure below 10 mbar. Typical levels of vacuum are between 10⁻² mbar and 10⁻⁴ mbar. The cycles as described are typically repeated until the coil is completely consumed or until web processing is discontinued. In typical applications of the present invention, it is possible to feed the web continuously to the web processing installation at a speed of between 1 - 25 meter/minute, such as 10 meter/minute.

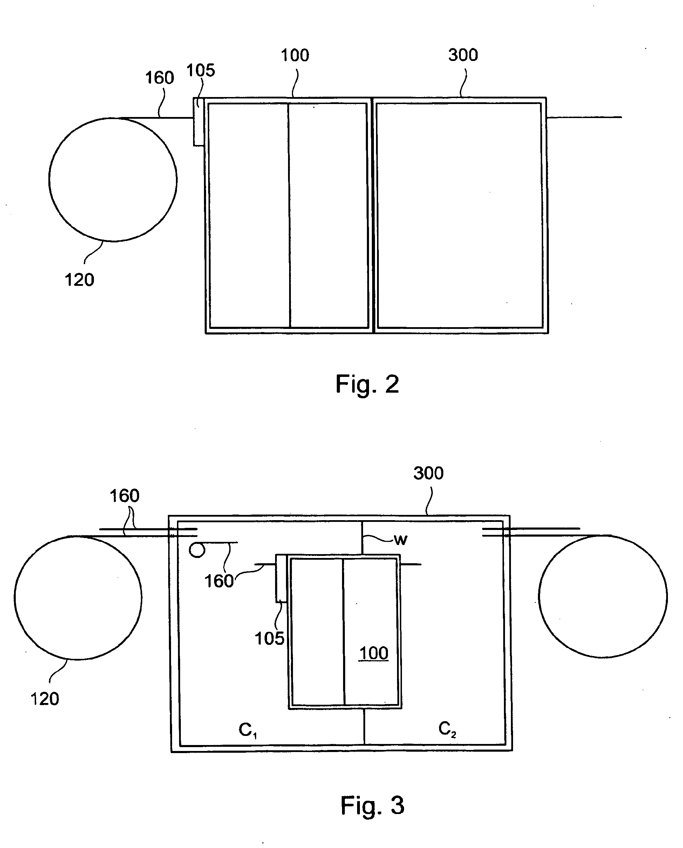

Fig. 2 shows an embodiment of a web processing installation according to the present invention. The at least one web processing chamber 300 is positioned downstream of the entry lock system 100. The entry lock system 100 typically comprises a first and a second chamber. The terms "downstream" and "upstream" within the present application are to be understood with respect to the travelling direction of the web. Typically, the at least one web processing chamber is in direct contact with the second chamber of the entry lock system. Thereby, the web stored within the second chamber of the entry lock system is directly fed to the following web processing chamber of the web processing installation.

Fig. 3 is a schematic illustration of an embodiment of the present invention. It shows that it is possible to arrange the entry lock system of the present invention within the web processing installation. Here again, the entry lock system 100 typically comprises a first and a second chamber. For instance, an arrangement of a web processing installation is possible wherein the material from the web coil is fed to a chamber other than the first and second chamber of the entry lock system and afterwards to the first chamber of the entry lock system. Alternative ways of supplying the web are: a continuous feeding to a chamber 300 in which the entry lock system is arranged, providing a coil within chamber 300 and use the functionality of the entry lock system within the larger chamber etc. In principal, a lot of arrangements within this invention are foreseeable which allow an advantageous use of the functionality of the lock entry system to continuously feed a web to a processing chamber without breaking the vacuum.

Within larger chamber 300 some process and/or handling steps of the web may occur prior to feeding the web to the entry lock system for storage. Rollers can be arranged within chamber 300 to guide web 160 from the entry port of chamber 300 to the entry port of the entry lock system 100. Chamber 300 can be subdivided into two chambers C1 and C2. A separation wall w between is positioned is such a way that the entry port and the exit port of entry lock system 100 are in communication with either C1 or C2. This will provide the additional option of potentially having two different vacuum stages prior to and after the lock entry system. It is a further technical option to have an additional lock entry system arranged after chamber 300.

There are several options to places vacuum seals in Fig. 3. Depending on the technical requirements a vacuum seal could be placed at the entry port of chamber 300 (not shown) and/or at the exit port of chamber 300 (not shown). A vacuum seal is shown at the entry port of entry lock system 100. In addition to that (or alternatively) a vacuum seal can also be placed at the exit port of entry lock system 100 (not shown).

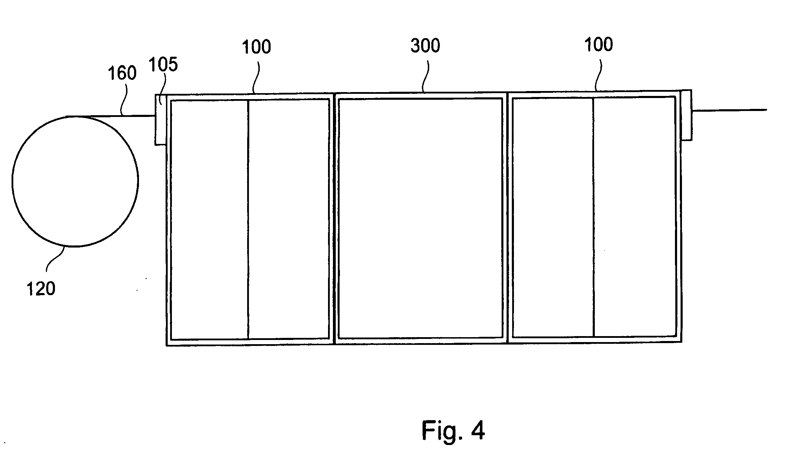

In principle, the entry lock system of the present invention may be applied at any stage within a web processing installation. In particular, as it is shown in Fig. 4, it is also possible to provide the outlet port of the web processing installation with the entry lock system of the present invention. This is in order to prevent the web processing installation from airing via the web exit of the web processing installation. When operating the entry lock system positioned at the exit of the web processing installation in a continuous mode, i.e. without stopping the reception of web to the first chamber, the operation of the entry lock system is similar to the one described above with regard to Fig. 1A, 1B and 1C. In particular, the steps may be as follows: the web storage unit of the first chamber may be filled. At this point in time, the second chamber has to be evacuated, and the second seal 205 between the first and second chamber is opened. The web stored in the first web storage unit is fed to the second web storage unit in the second chamber. Typically, the second chamber is provided with a seal at the outlet port of the second chamber when it is operated downstream of a web processing installation. This seal has to be shut when the web is fed from the first chamber to the second chamber. Once the second web storage unit is filled, the seal between the first chamber and the second chamber is shut whereas the seal at the second chamber outlet port is opened for leading the web away, typically for coiling it. During emptying the second web storage unit in the second chamber, the first web storage unit in the first chamber is refilled with web that may be continuously fed to the first chamber.

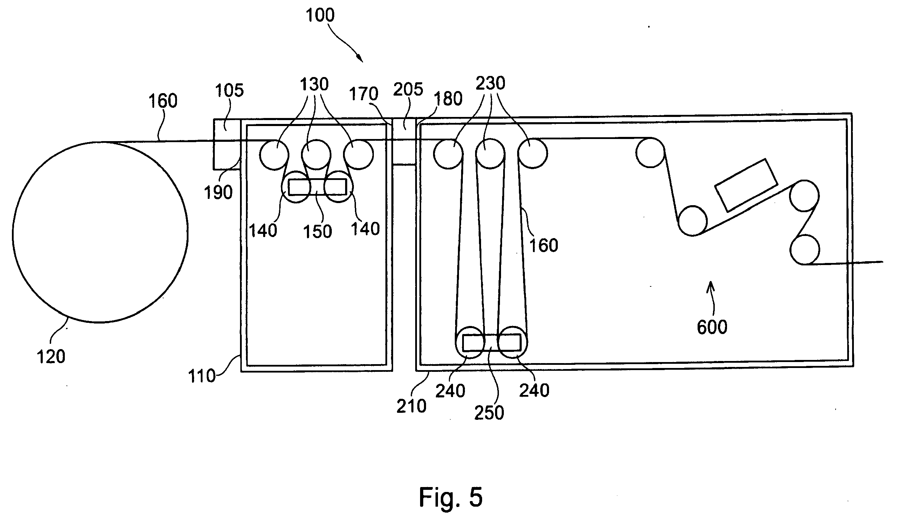

Fig. 5 shows another embodiment of the entry lock system according to the present invention. As shown, it is possible according to the present invention that the second chamber is part of the web processing installation. Typically, the second web storage unit is positioned upstream of a web processing application. In the embodiment shown in Fig. 5, an exemplary web processing application is depicted and referred to with number 600. For instance, the web processing application could be cleaning application, a sputtering application, a coating application etc. It is generally possible according to the present invention that there is no seal and/or no wall between the second chamber of the entry lock system and the following web processing application of the web processing installation. Further, it is possible that the web 160 exits the web processing installation such as shown in Fig. 5 and is coiled outside of the web processing installation(not shown), or the web is coiled within the web processing installation.

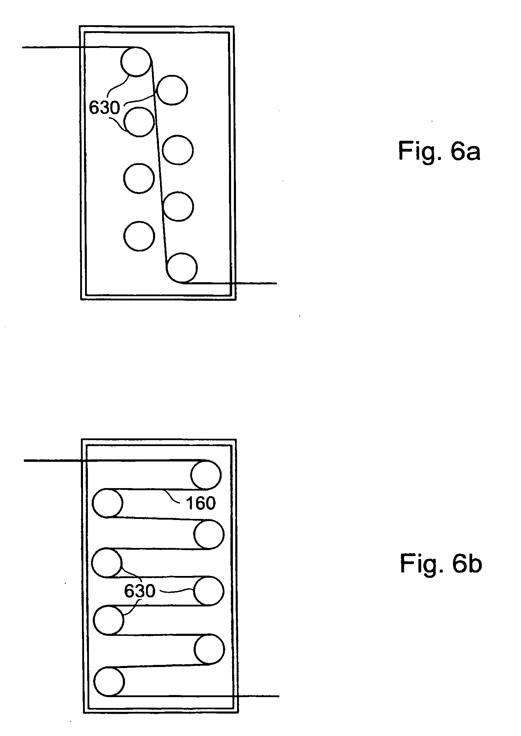

Figs. 6a and 6b show another embodiment of a chamber with a web storage unit according to the present invention. The chamber shown in Figs. 6a and 6b can be used as first chamber and/or second chamber in the entry lock system according to the present invention. The chamber comprises at least two rollers 630 which serve as a web storage unit. The rollers are movable in a lateral direction. They may be connected by one, two or more carriages.

The web storage unit shown in Figs. 6a and 6b works as follows: The web is mounted as shown in Fig. 6a. In order to store web, part of the rollers move to the left, and another part of the rollers move to the right until they reach a position that is shown in Fig. 6b. A drive such as an electromotor drive or a hydraulic drive may be used in order to move the rollers. Typically, the rollers are moved until they are close to the wall as in this situation the web storage unit is filled. In typical embodiments of the present invention, the rollers may move on a guide rail.

When the web storage unit is emptied, the rollers are moving towards the opposite rollers until a position is reached that is shown in Fig. 6a. The correct timing for shutting the first and second seal is as described previously.

The storing technique described with respect to Fig. 6a and 6b can be used in all embodiments of the present invention. Another alternative is the use of rollers which can move in a radial direction from a central position of the storage chamber towards the storage chamber walls. This also allows the storage of web material in one chamber prior to feeding it to a second chamber.

Mutually non-exclusive features of the embodiments described above may be combined with each other. The patentable scope of the invention is defined by the claims.

## Claims

1. An entry lock system (100) for feeding web from a web supply (120) to a web processing installation (300), the entry lock system comprising
a) a first chamber (110) having an inlet port (190) for the web and an outlet port (170) for the web;
b) a second chamber (210) having an inlet port (180) for the web;
c) a first seal (105) positioned at the inlet port for the web of the first chamber for sealing the inlet port;
d) a second seal (205) positioned between the first chamber and the second chamber for sealing the second chamber from the first chamber;
e) a first web storage unit (130, 140, 150) positioned in the first chamber; and
f) a second web storage unit (230, 240, 250) positioned in the second chamber.

2. The entry lock system according to the preceding claim wherein the second chamber has an outlet port (195) that is linked to the web processing installation (300).

3. The entry lock system according to any of the preceding claims wherein the first and/or second chamber comprise at least one vacuum pump.

4. The entry lock system according to any of the preceding claims wherein the first and/or second web storage unit comprises a multitude of rollers (130, 140; 230, 240).

5. The entry lock system according to any of the preceding claims wherein the first and/or second seal are flexible vacuum seals.

6. The entry lock system according to any of the preceding claims wherein the first and/or second seal are inflatable seals.

7. The entry lock system according to any of the preceding claims wherein the first and/or second seal are shutter seals.

8. The entry lock system according to any of the preceding claims wherein the first and/or second web storage unit comprises at least one movable roller (140; 240) for moving within the web storage unit.

9. The entry lock system according to claim 8 wherein the moving is a one-dimensional translation movement.

10. The entry lock system according to claim 8 or 9 with at least two movable rollers, wherein the at least two movable rollers are connected via a carriage (150; 250).

11. The entry lock system according to any of the preceding claims wherein the first chamber and the second chamber are in direct contact to each another.

12. The entry lock system according to any of the preceding claims wherein the second seal is positioned at the outlet port of the first chamber and/or at the inlet port of the second chamber.

13. A web processing installation having at least one entry lock system according to any of claims 1 to 12.

14. The web processing installation according to claim 13 wherein the second chamber is part of the web processing installation.

15. The web processing installation according to claim 13 or 14 with one entry lock system arranged at an inlet port of the web processing installation and/or one entry lock system arranged at the outlet port of the web processing installation.

16. A method for feeding a web processing installation (300) with web comprising the steps of:
a) feeding the web from ambient air to a first chamber (110) having a first pressure;
b) storing the web fed to the first chamber in the first chamber;
c) sealing the first chamber and evacuating the first chamber to a second pressure;
d) feeding the web stored in the first chamber to a second chamber (210) having a third pressure;
e) storing the web fed to the second chamber in the second chamber; and
f) sealing the second chamber from the first chamber.

17. The method for feeding a web processing installation according to claim 16 further comprising the step of feeding the web stored in the second chamber to a web processing application of the web processing installation.

18. The method for feeding a web processing installation according to claim 16 or 17 wherein the steps a)-f) are repeated at least one time, typically at least ten times.

19. The method for feeding a web processing installation according to any of claims 16 to 18 wherein the step c) is undertaken after steps a) and b), and/or step f) is undertaken after steps d) and e).

20. The method for feeding a web processing installation according to any of claims 16 to 19 wherein the feeding to the web processing installation is continuous.

21. The method for feeding a web processing installation according to any of claims 16 to 20 wherein the second pressure and the third pressure are identical.

## Patentansprüche

1. Ein Zuführungsverschlusssystem (100) zum Zuführen eines Bands von einer Bandversorgung (120) zu einer Bandbearbeitungseinrichtung (300), wobei das Zuführungsverschlusssystem umfasst
a) eine erste Kammer (110) mit einer Einlassöffnung (190) für das Band und einer Auslassöffnung (170) für das Band;
b) eine zweite Kammer (210) mit einer Einlassöffnung (180) für das Band;
c) eine erste Dichtung (105) zum Dichten der Einlassöffnung angeordnet an der Einlassöfnung für das Band der ersten Kammer;
d) eine zweite Dichtung (205) zum Abdichten der zweiten Kammer von der ersten Kammer, wobei die zweite Dichtung zwischen der ersten Kammer und der zweiten Kammer angeordnet ist;
e) eine erste in der ersten Kammer angeordnete Bandspeichereinheit (130, 140, 150); und
f) eine in der zweiten Kammer angeordnete zweite Bandspeichereinheit (230, 240 ,250).

2. Das Zuführungsverschlusssystem nach dem vorhergehenden Anspruch, wobei die zweite Kammer eine Auslassöffnung (195) hat, die mit der Bandbearbeitungseinrichtung (300) verbunden ist.

3. Das Zuführungsverschlusssystem nach einem der vorhergehenden Ansprüche, wobei die erste und/oder zweite Kammer mindestens eine Vakuumpumpe umfasst.

4. Das Zuführungsverschlusssystem nach einem der vorhergehenden Ansprüche, wobei die erste und/oder zweite Bandspeichereinheit eine Mehrzahl von Rollen (130, 140; 230, 240) umfasst.

5. Das Zuführungsverschlusssystem nach einem der vorhergehenden Ansprüche, wobei die erste und/oder zweite Dichtung elastische Vakuumdichtungen sind.

6. Das Zuführungsverschlusssystem nach einem der vorhergehenden Ansprüche, wobei die erste und/oder zweite Dichtung aufblasbare Dichtungen sind.

7. Das Zuführungsverschlusssystem nach einem der vorhergehenden Ansprüche, wobei die erste und/oder zweite Dichtung Verschlussdichtungen sind.

8. Das Zuführungsverschlusssystem nach einem der vorhergehenden Ansprüche, wobei die erste und/oder zweite Bandspeichereinheit mindestens eine bewegliche Rolle (140; 240) zum Bewegen innerhalb der Bandspeichereinheit umfasst.

9. Das Zuführungsverschlusssystem gemäß Anspruch 8, wobei das Bewegen eine eindimensionale Translationsbewegung ist.

10. Das Zuführungsverschlusssystem nach Anspruch 8 oder 9 mit mindestens zwei beweglichen Rollen, wobei die mindestens zwei beweglichen Rollen über einen Schlitten (150; 250) verbunden sind.

11. Das Zuführungsverschlusssystem nach einem der vorhergehenden Ansprüche, wobei die erste Kammer und die zweite Kammer in unmittelbarem Kontakt zueinander stehen.

12. Das Zuführungsverschlusssystem nach einem der vorhergehenden Ansprüche, wobei die zweite Dichtung an der Auslassöffnung der ersten Kammer und/oder an der Einlassöffnung der zweiten Kammer angeordnet ist.

13. Eine Bahnverarbeitungseinrichtung mit mindestens einem Zuführungsverschlusssystem nach einem der Ansprüche 1 bis 12.

14. Die Bahnverarbeitungseinrichtung nach Anspruch 13, wobei die zweite Kammer Teil der Bahnverarbeitungseinrichtung ist.

15. Die Bahnverarbeitungseinrichtung gemäß Anspruch 13 oder 14 mit einem Zuführungsverschlusssystem, das an der Einlassöffnung der Bahnverarbeitungseinrichtung angeordnet ist, und/oder ein Zuführungsverschlusssystem, das an der Auslassöffnung der Bahnverarbeitungseinrichtung angeordnet ist.

16. Ein Verfahren zum Zuführen einer Bahn zu einer Bahnverarbeitungseinrichtung (300), umfassend die Schritte
a) Zuführen der Bahn aus Umgebungsluft zu einer ersten Kammer (110), die einen ersten Duck aufweist;
b) Speichern der der ersten Kammer zugeführten Bahn in der ersten Kammer;
c) Abdichten der ersten Kammer und Entleeren der ersten Kammer auf einen zweiten Druck;
d) Zuführen der in der ersten Kammer gespeicherten Bahn zu einer zweiten Kammer (210), die einen dritten Druck aufweist;
e) Speichern der der zweiten Kammer zugeführten Bahn in der zweiten Kammer; und
f) Abdichten der zweiten Kammer von der ersten Kammer.

17. Das Verfahren zum Zuführen einer Bahn zu einer Bahnverarbeitungseinrichtung nach Anspruch 16, des Weiteren umfassend den Schritt des Zuführens von der in der zweiten Kammer gespeicherten Bahn zu einer Bahnverarbeitungsanwendung der Bahnverarbeitungseinrichtung.

18. Das Verfahren zum Zuführen einer Bahn zu einer Bahnverarbeitungseinrichtung nach Anspruch 16 oder 17, wobei die Schritte a)-f) mindestens einmal, typischerweise mindestens zehnmal wiederholt werden.

19. Das Verfahren zum Zuführen einer Bahn zu einer Bahnverarbeitungseinrichtung nach einem der Ansprüche 16 bis 18, wobei der Schritt c) nach den Schritten a) und b) ausgeführt wird und/oder der Schritt f) nach den Schritten d) und e) ausgeführt wird.

20. Das Verfahren zum Zuführen einer Bahn zu einer Bahnverarbeitungseinrichtung nach einem der Ansprüche 16 bis 19, wobei das Zuführen der Bahn zu der Bahnverarbeitungseinrichtung kontinuierlich erfolgt.

21. Das Verfahren zum Zuführen einer Bahn zu einer Bahnverarbeitungseinrichtung nach einem der Ansprüche 16 bis 20, wobei der zweite Druck und der dritte Druck identisch sind.

## Revendications

1. Système (100) de sas d'entrée pour acheminer un voile depuis une alimentation en voile (120) jusqu'à une installation de traitement de voile (300), le système de sas d'entrée comprenant :
a) une première chambre (110) ayant un orifice d'entrée (190) pour le voile et un orifice de sortie (170) pour le voile ;
b) une seconde chambre (210) ayant un orifice d'entrée (180) pour le voile ;
c) un premier joint (105) positionné au niveau de l'orifice d'entrée pour le voile dans la première chambre pour fermer hermétiquement ledit orifice d'entrée ;
d) un second joint (205) positionné entre la première chambre et la seconde chambre pour isoler hermétiquement la seconde chambre de la première chambre ;
e) une première unité de stockage de voile (130, 140, 150) positionnée dans la première chambre, et
f) une seconde unité de stockage de voile (230, 240, 250) positionnée dans la seconde chambre.

2. Système de sas d'entrée selon la revendication précédente, dans laquelle la seconde chambre (210) a un orifice de sortie (195) qui est relié à l'installation de traitement de voile (300).

3. Système de sas d'entrée selon l'une quelconque des revendications précédentes, dans laquelle la première et/ou la seconde chambre(s) comprend/comprennent au moins une pompe à vide.

4. Système de sas d'entrée selon l'une quelconque des revendications précédentes, dans laquelle la première et/ou la seconde unité(s) de stockage de voile comprend/comprennent une multitude de rouleaux (130,140 ; 230,240).

5. Système de sas d'entrée selon l'une quelconque des revendications précédentes, dans laquelle le premier et/ou le second joint(s) est/sont des joints à vide, souples.

6. Système de sas d'entrée selon l'une quelconque des revendications précédentes, dans laquelle le premier et/ou le second joint(s) est/sont des joints gonflables.

7. Système de sas d'entrée selon l'une quelconque des revendications précédentes, dans laquelle le premier et/ou le second joint(s) est/sont des joints de volet.

8. Système de sas d'entrée selon l'une quelconque des revendications précédentes, dans laquelle la première et/ou la seconde unité(s) de stockage de voile comprend/comprennent au moins un rouleau mobile (140 ; 240) pour se déplacer à l'intérieur de l'unité de stockage de voile.

9. Système de sas d'entrée selon la revendication 8, dans lequel le déplacement est un mouvement en translation monodimensionnel.

10. Système de sas d'entrée selon la revendication 8 ou 9, ayant au moins deux rouleaux mobiles, dans laquelle lesdits au moins deux rouleaux mobiles sont connectés via un chariot (150 ; 250).

11. Système de sas d'entrée selon l'une quelconque des revendications précédentes, dans laquelle la première chambre et la seconde chambre sont en contact direct l'une avec l'autre.

12. Système de sas d'entrée selon l'une quelconque des revendications précédentes, dans laquelle le second joint est positionné au niveau de la première chambre et/ou au niveau de la seconde chambre.

13. Installation de traitement de voile ayant au moins un système de sas d'entrée selon l'une quelconque des revendications 1 à 12.

14. Installation de traitement de voile selon la revendication 13, dans laquelle la seconde chambre fait partie de l'installation de traitement de voile.

15. Installation de traitement de voile selon la revendication 13 ou 14, ayant un système de sas d'entrée agencé au niveau d'un orifice d'entrée de l'installation de traitement de voile et/ou un système de sas d'entrée agencé au niveau de l'orifice de sortie de l'installation de traitement de voile.

16. Procédé d'alimentation en voile d'une installation de traitement de voile, comprenant les étapes de :
a) acheminement du voile depuis l'air ambiant vers une première chambre (110) ayant une première pression ;
b) stockage, dans la première chambre, du voile acheminé vers la première chambre ;
c) fermeture hermétique de la première chambre (110) et application d'un vide à la première chambre jusqu'à une seconde pression ;
d) acheminement du voile depuis la première chambre vers une seconde chambre (210) ayant une troisième pression ;
e) stockage, dans la seconde chambre, du voile acheminé vers la seconde chambre ; et
f) isolement hermétique de la seconde chambre d'avec la première chambre.

17. Procédé d'alimentation en voile d'une installation de traitement de voile selon la revendication 16, comprenant, en outre, l'étape d'alimentation, en le voile stocké dans la seconde chambre, d'une application de traitement de voile de l'installation de traitement de voile.

18. Procédé d'alimentation en voile d'une installation de traitement de voile selon la revendication 16, dans lequel les étapes a)-f) sont répétées au moins une fois, habituellement au moins dix fois.

19. Procédé d'alimentation en voile d'une installation de traitement de voile selon l'une quelconque des revendications 16 à 18, dans lequel l'étape c) est entreprise après les étapes a) et b), et/ou l'étape f) est entreprise après les étapes d) et e).

20. Procédé d'alimentation en voile d'une installation de traitement de voile selon l'une quelconque des revendications 16 à 19, dans lequel l'alimentation de l'installation de traitement de voile est continue.

21. Procédé d'alimentation en voile d'une installation de traitement de voile selon l'une quelconque des revendications 16 à 20, dans lequel la seconde pression et la troisième pression sont identiques.
